# EUROPEAN PATENT APPLICATION

(11) **EP 1 988 758 A1**
(43) Date of publication of application: **05.11.2008**
(21) Application number: 07708420.0
(22) Date of filing: 20.02.2007
(51) Int. Cl.: H05K 1/11, H05K 3/40, H05K 3/46

(54) **PRINTED WIRING BOARD AND PROCESS FOR PRODUCING THE SAME**

(30) Priority: 22.02.2006 JP 2006044968
(71) Applicant: IBIDEN CO., LTD., Ogaki-shi Gifu 503-8604 (JP)
(72) Inventor: IKEDA, Tomoyuki c/o IBIDEN CO., LTD., Ibigun, Gifu 501-0695 (JP)
(74) Representative: Grünecker, Kinkeldey, Stockmair & Schwanhäusser Anwaltssozietät
(86) International application number: PCT/JP2007/053455
(87) International publication number: WO 2007/097440

(57) **Abstract**

To provide a printed wiring board having through-holes made by plating perforations formed on the insulating resin base material, wherein the position of an axis of the center of gravity of each of the through-holes exposed from the front surface and back surface of the insulating resin base material is out of alignment with each other to reduce defects such as voids and cracking in order to reduce poor connection and to improve the mechanism strength of the wiring board.

## Description

### Technical Field

The present invention is related to a printed wiring board wherein a plated conductor is formed in penetrating holes formed in an insulating material, and specifically to a printed wiring board and a method of production thereof to improve poor conduction of a plated conductor and to increase the strength of the substrate.

### Background Technology

In a conventional printed wiring board, there is a filled type of through-hole made by plating to fill a metal in penetrating holes formed in an insulating resin base material as a plated through-hole for electrically connecting conductor circuits each formed on the front surface and back surface of the insulating resin base material to form a core.

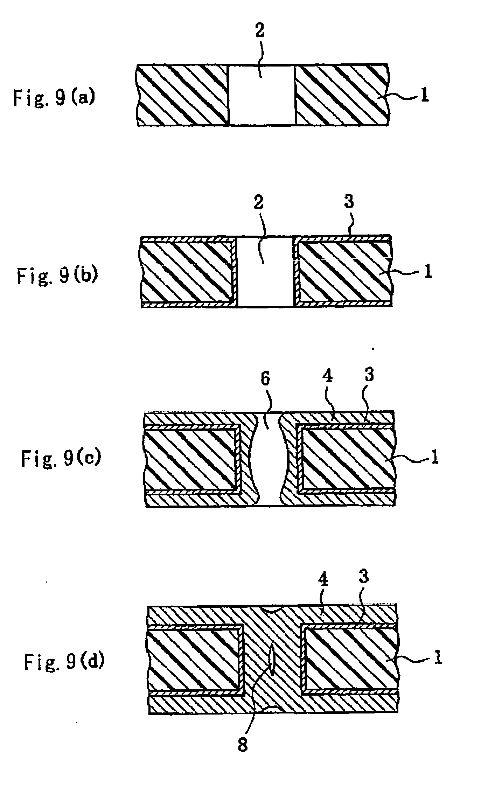

For example, Japan Patent Kokai (Unexamined patent publication) No. 2004-311919 describes a method of forming through-holes and the like as conventional technology. To form a through-hole, first, after the penetrating hole 2 is formed in the insulating resin base material 1 as shown in Fig. 9 (a), the seed layer 3 is made of metal by nonelectrolytic plating on the surface of the insulating resin base material 2, including the inner wall surface of the penetrating hole as shown in Fig. 9 (b).

Then, electrolytic plating is performed using the seed layer 3 as a power-feeding layer to form the electrolytically plated layer 4 on the seed layer 3. This electrolytically plated layer 4 has the portion formed on the corners of the opening portion of the perforation 2, which is thicker than the portion formed on the inside section of the perforation 2 as shown in Fig. 9 (c).

In addition, by performing an electrolytic plating process, the through-hole 6 is formed by filling the perforation 2 with metals, and the electrolytically plated layer 4 may be made to a preferred thickness as shown in Fig.9 (d).

Then, by making patterns on this electrolytic plated layer 4, a preferred wiring pattern is formed on the front surface and back surface of the insulating resin base material 1 and a wiring board in which the through-hole 6 is formed for connecting the wiring pattern electrically may be obtained.

However, there was a problem that the void 8 is prone to be formed inside the through-hole formed in a method such as shown in Fig. 9 (d).

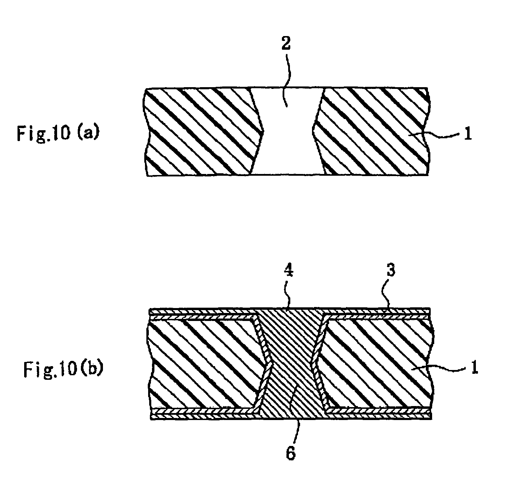

Therefore, a technology is suggested that enables forming of a through-hole free of defects such as a void (e.g., refer to Patent Reference described above). According to this method, a through-hole 6 in which few defects such as voids appear is formed by filling the metal 4 in a drum-shaped penetrating hole by performing an electrolytic plating process using this seed layer as a power-feeding layer, followed by forming a seed layer 3 made of metals by electroless plating after a penetrating hole 2, in which the vertical cross-section is a drum shape, is formed in the insulating resin base material 1 as shown in Fig. 10 (a) to (b).
However, in a printed wiring board having a through-hole in which the vertical cross-section is in a drum shape as described above, because the through-hole made by plating is in a shape that has a so-called neck portion in which the diameter decreases toward the center portion from the surface opening and which is almost symmetrical around the center axis, when the insulating resin material is warped, stress is easily concentrated around the neck portions of the through-hole. Consequently, it becomes prone to cracking around the neck portion, and due to the cracking, there are issues such as poor connection occurring or sufficient mechanical strength being unable to be obtained because the substrate is prone to become broken.
Therefore, the object of the present invention is to provide a printed wiring board that has a through-hole structure to reduce poor connection of the substrate and to improve mechanical strength of the substrate not only by reducing defects such as voids but also by reducing cracking.

### Disclosure of the Invention

The inventor found that in a through-hole structure made by plating in a drum-shape in its cross-section, for example, the diameter of both a first opening portion exposed on one side of the substrate and a second opening portion on the other side of the substrate decreases toward the center part of the substrate and around the center part, a uniformed shape, i.e., in a through-hole structure having a drum-shape in its cross-section, when the axis of the center of gravity of the first opening portion and the axis of the center of gravity of the second opening position are out of alignment with each other in a predefined range, good filling is obtained by plating, and the stress to which the plated through-hole is subjected is reduced efficiently after considerations to resolve the issue described above, to achieve the present invention.

In other words, the inventor invented
(1) A printed wiring board having a through-hole filling a penetrating hole provided in an insulating resin base material with a plating, wherein the position of axis of the center of gravity of each through-hole exposed from the front surface and back surface of said insulating resin base material is out of alignment with each other.

In addition, the present invention is
(2) A multilayer printed wiring board having a through-hole filling a penetrating hole provided in an insulating resin base material with a plating, wherein a resin insulating layer and an external layer of a conductor circuit are alternately formed on a core substrate having an inner layer of a conductor circuit electrically connected via said through-holes on both the front surface and back surface of said insulting resin base material;
wherein the position of axis of the center of gravity of each through-hole exposed from the front surface and back surface of said insulating resin base material is out of alignment with each other.

In the invention described in (1) and (2) above, said misalignment distance may be in a range of 5-30 µm. Furthermore, in this invention, the thickness of said insulating resin base material may be in a range of 100-500 µm. Moreover, in this invention, said through-hole may be formed, whereby the diameter decreases inward from each of the front surface and back surface of the insulating resin base material to form a neck portion, i.e., in a drum shape such as having a neck portion inside, and the diameter of the opening exposed on each of the front surface and back surface of the insulating resin base material may be 75-300 µm, while the diameter of the neck portion inside the insulating resin base material may be 50-250 µm. In addition, the pitch between adjacent through-holes may be in a range of 100-400 µm.
"The axis of the center of gravity" refers to a straight line passing through the center of gravity of an opening portion of the through-hole on the front surface (back surface) of the core substrate and is substantively perpendicular to the front surface (back surface) of the core substrate.

In addition, the present invention is related to a method of producing a printed wiring board, wherein
(3) to produce a printed wiring board having a through-hole filling a penetrating hole passing through an insulting resin base material with a plating, and having conductor circuits electrically connected via said through-holes on the front surface and back surface of said insulting resin base material,
which includes at least steps (1) to (4) below, as follows:
(1) A step of forming a first opening portion having a shape in which the diameter decreases depthwise of the insulating resin base material by irradiating, with a laser, a predetermined position on one surface of a copper clad laminate on which copper foil is laminated on both sides of the insulating resin base material;
(2) A step of forming a second opening portion for connection with said first opening portion around the center of the depth of the insulating resin base material, and for forming a shape in which the diameter decreased inward of said insulating resin base material by irradiating, with a laser, a position that does not overlap the position of the center of gravity of said first opening portion from a location on another surface of said copper clad laminate facing to said predetermined position across said insulating resin base material;
(3) A step of forming an electroless plated film on the inner wall of said first and a second opening portion by performing electroless plating on said base material;
(4) A step of forming an electrolytic plated layer on said electroless plated film and forming through-holes filled with plating inside said first and second opening portions by performing electrolytic plating on said base material.
Furthermore, between step (2) and step (3) described above, a step of removing resin residue left inside said first and second opening portions.

### Brief Description of Drawings

Fig. 1 is a schematic view for describing the shape of the through-hole on the printed wiring board according to the present invention.
Fig. 2 is a schematic view indicating the cross-section of a connection of the neck portion of the through-hole.
Fig. 3 is a schematic view showing an example when the position of the center of gravity varies for adjacent through-holes.
Fig. 4 (a) to (d) are drawings indicating some of the steps for producing a printed wiring board according to one embodiment of the present invention.
Fig. 5 (a) to (d) are drawings showing some of the steps for producing a printed wiring board according to one embodiment of the present invention.
Fig. 6 (a) to (d) are drawings showing some of the steps for producing a printed wiring board according to one embodiment of the present invention.
Fig. 7 (a) to (b) are schematic views showing a deformation shape when misalignment of the position of the center of gravity of the through-hole is considerable.
Fig. 8 is a schematic view showing a through-hole made by filling filler into gaps enclosed by through-hole conductors after the through-hole conductors are formed on the inner walls of perforations.
Fig. 9 (a) to (d) are drawings showing the production process of the printed wiring board according to conventional technology.
Fig. 10 (a) to (b) are drawings for describing through-hole shapes on other printed wiring boards according to conventional technology.

### Best Embodiment According to the Invention

The printed wiring board according to the present invention is characterized as incorporating a printed wiring board having a plated conductor inside a penetrating hole formed in an insulating resin base material or a printed wiring board such as a core substrate, and in a multiplayer printed wiring board formed with a conductor layer and a resin insulating layer alternatively on the core substrate, the position of the center of gravity of the through-hole exposed on the front surface of said insulating resin base material and the position of the center of gravity of the through-hole exposed on the back surface of said insulating resin substrate are out of alignment with each other.

As described above, by arranging the position of the axis of the center of gravity of through-holes each exposed on the front surface and back surface of an insulating resin base material, the area where the neck portion of the through-hole, i.e., the cross-section area that is cut by a plane parallel to the front surface or back surface of the insulating resin base material is minimized, becomes out of alignment; therefore, even the insulating resin base material is warped, the area on which stress is applied becomes wider for the amount of misalignment of the neck portion, or because the front surface of the core substrate and the plane made by connecting the center of gravity of each neck portion do not become come in alignment with each other, the stress is reduced, making it difficult for cracks to form around the neck portion. Consequently, poor connection due to cracking becomes unlikely to occur, and mechanical strength of the base material may be improved.

Alternatively, they may be formed so that the position of the center of gravity of the neck portion differs among adjacent through-holes.

In addition, because the cross-sectional area becomes larger around the neck portion of the through-hole, the conduction resistance decreases and the electric property of the base material may improve.

In addition, in the multilayer printed wiring board according to the present invention, it is preferable to form some of the outermost conductor layer as a pad for connecting bumps at a predetermined pitch, and to keep misalignment of the position of the center of gravity of the front surface of each through-hole exposed from the front surface and back surface of said insulating resin base material in addition to forming the pitch between adjacent through-holes similar to the pitch of said pad for connecting bumps.

As an insulating resin base material used in the present invention, it is preferable to use a hard base material selected from among glass fabric epoxy resin base material, glass fabric bismaleimide-triazine resin base material, glass fabric polyphenylenether resin base material, non-woven aramid-epoxy resin base material, and non-woven aramid-polyimide resin material, and more preferable to use glass fabric epoxy resin base material.

The thickness of said insulating resin base material is preferably about 100-500 µm. This is because, if the thickness is less than 100 µm, the rigidity is sufficient, but if it is thicker than 500 µm, it becomes difficult to plate into the through-hole, which may resulting in plating voids.

The conductor circuit formed on both surfaces of such an insulating resin base material is, as described later, after plating the through-holes, preferably formed by etching on a metal foil laminated on both sides of the insulating resin base material and the plated layer formed thereon.

A base material consisting of said insulating resin base material and a metal foil, in particular, may use a double-sided copper clad laminate obtained by laminating and heat-pressing prepreg as a B stage by impregnating epoxy resin in glass cloth and copper foils. Such a base material is good for positioning accuracy, because there is no misalignment of the wiring pattern or via position during handling after copper foils are etched.

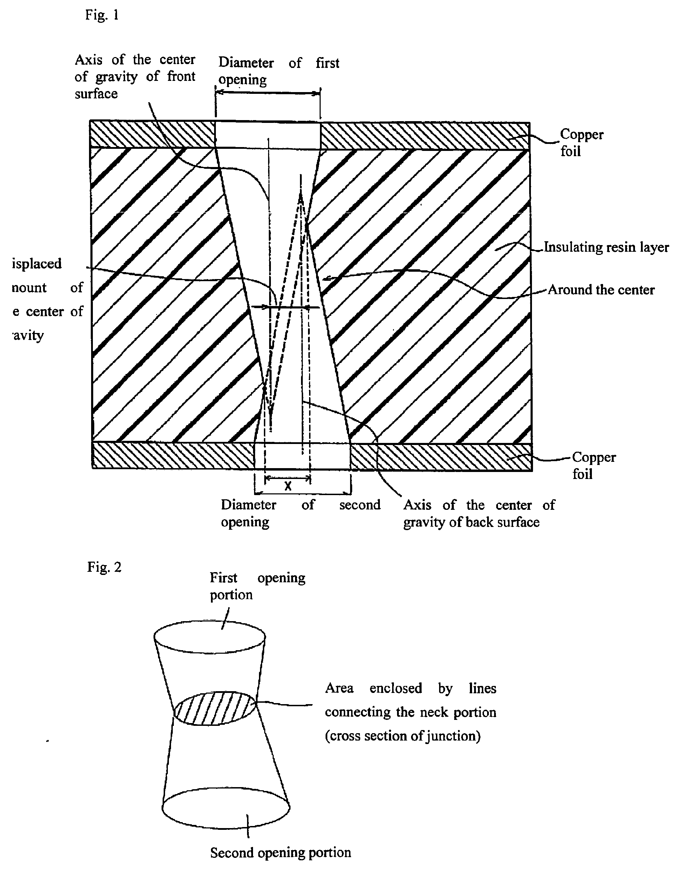

The through-hole according to the first embodiment of the present invention, for example, as shown in Fig. 1, comprises a first opening portion having a shape in which the diameter decreases inward from the one side of the insulating base material and a second opening portion having a shape in which the diameter decreases inward from the other side of insulating base material, and connecting to said first opening portion around the center depthwise of said insulating resin material, and a neck portion is formed at the point at which the first opening portion and the second opening portion coincide. In other words, a drum-shaped penetrating hole is filled with plating; the penetrating hole is out of alignment toward the base material surface direction by a predetermined distance as a whole, and the axes of the center of gravity (straight lines passing through the center of gravity of the first opening portion and the second portion, and substantively vertical to the front (back) surface of the base material) of the first opening portion and the second opening portion each exposed on one side and the other side of said insulating resin base material are out of alignment with each other.

It is preferable to form the through-hole described above by laser processing penetrating holes each comprising a first opening portion and a second portion, and then by filling those penetrating holes with metal plating.

Furthermore, to improve the degree of efficiency of absorbing the laser beam in the laser processing, it is preferable to perform a well-known black oxide process on the metal foil on the insulating resin base material in advance.

To form penetrating holes for forming through-holes with laser processing, first, irradiate with a laser from a predefined position toward one side of the insulating resin base material to form the first opening portion in which the diameter decreases inward from one side of the insulating resin base material and that extends around the center from the one side of the insulating resin base material. Then, from a misaligned position by a predefined distance from the surface position of the other side of the insulating resin base material across from said predefined position, by irradiating with laser toward the other surface of the insulating resin base material, it is preferable to form penetrating holes for forming through-holes by connecting the first opening position and the second opening position around the center of the insulating resin base material, and the second opening portion is formed whereby the diameter decreases inward from the other surface of the insulating resin base material and extends around the center from the other surface of the insulating resin base material.

To form penetrating holes for forming through-holes by using laser on said insulating resin base material, there are two methods: the direct laser method for perforating both the metal foil and the insulating resin base material at the same time with laser irradiation, and the conformal method for penetrating the insulating resin base material with laser irradiation after the metal foil part to be a penetrating hole in the metal foil is removed by etching. The present invention may use either one.

It is preferable to perform the laser process described above with a pulse-oscillated type of carbonic acid gas laser device. The process conditions are determined by the shape of penetrating holes (the first opening portion and the second opening portion) for forming through-holes in which the diameter decreases inward from the front surface of the insulating resin base material, i.e., the degree determined by the front surface of the insulating resin base material and the side wall of the penetrating hole (hereinafter referred to as the "taper" angle), and the depth of penetrating holes.

For example, by deciding on the range of pulse duration as 10-20 µs and the number of shots as a range of 1-5, the taper angle and the depth of penetrating holes for forming through-holes may be adjusted.

Furthermore, it is preferable to have penetrating holes for forming through-holes that may be formed under the process condition described above whereby the diameter (shown as the symbol X in Fig. 1) of the neck portion inside the insulating resin base material is 50-250 µm. If the diameter is less than 50 µm, it is too thin, so the connection reliability of through-holes filled with plating is poor, but if the diameter is more than 250 µm, it is prone to cause voids in through-holes filled with plating. Therefore, through-holes may be formed with fewer voids caused and the connection reliability within the range described above.

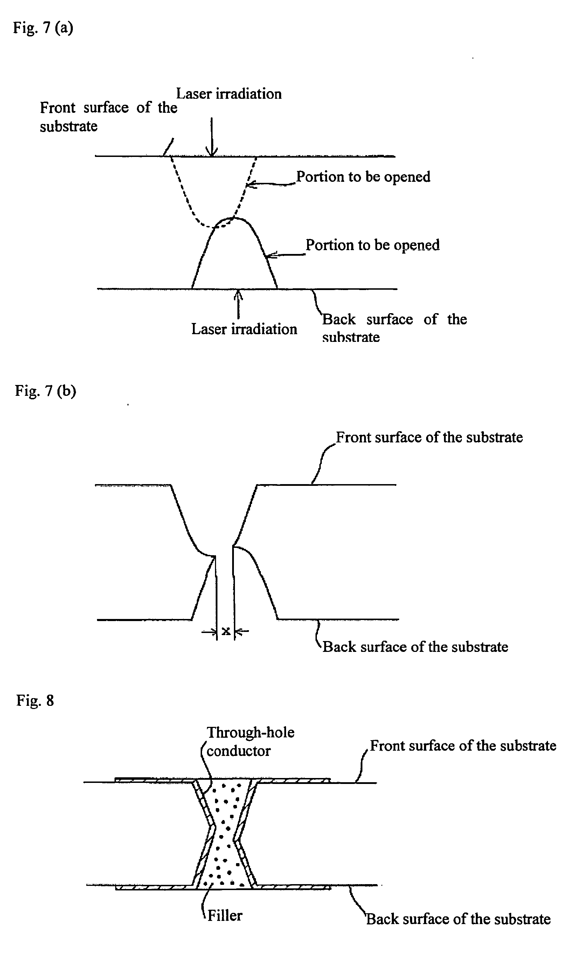

Moreover, it is preferable for the amount of misalignment of the position of the center of gravity for penetrating holes for forming through-holes described above to be within a range of 5-30 µm. This is because, if the amount of misalignment is less than 5 µm, the stress reduction effect is small, but if the amount of misalignment is more than 30 µm, the shape of the penetrating holes is prone to deformation as shown in Fig. 7 (a) to (b).

In addition, it is preferable for the pitch between adjacent through-holes to be 100-400 µm. This is because, if the pitch is less than 100 µm, the insulation reliability is low, but if the pitch is more than 400 µm, it is not suitable for fining.

Still further, it is preferable to perform the desmear process to remove resin residue left on the side of perforations formed by laser irradiation. This desmear process is performed by a wet process such as a chemical reaction of acids or of oxidants (e.g., chrome acid, permanganic acid), by a dry process such as oxygen plasma discharge treatment, corona discharge treatment, ultra violet laser processing, or an excimer laser process.

Which method to choose from among these desmear process methods depends on the type or thickness of the insulating base material, the diameter of the opening of the via-hole, or the laser irradiation conditions, considering the smear amount expected to be left.

In the present invention, to form through-holes by filling with plating in said penetrating holes, it is preferable to form an electroless plated film first by normal nonelectrolytic plating on the inner wall of the penetrating holes, and then to fill the through-holes with plating via an electrolytic plating process such as the sparger plating method, which causes the plating solution to flow onto the base material.

For the nonelectrolytic plating or electrolytic plating described, it is preferable to have metal plating such as using copper, tin, silver, various types of solder, metal plating such as copper/tin or copper/silver, and in particular, nonelectrolytic plating or electrolytic copper plating is best.

In the present invention, it is preferable to form the conductor circuit formed on both sides of the insulating resin base material via an etching process of the conductor layer formed at the same time as the plated through-holes are formed.

In this conductor circuit formation process, first, photosensitive dry film resist is laminated onto the surface of said conductor layer, and then exposed according to a predefined circuit pattern and developed to form an etching resist, and by etching the conductor layer on parts where etching resists are not formed to create a conductor circuit pattern containing electrode pads.

In the process step described above, as an etching solution, at least one type of water solution may be used selected from among sulphate hydrogen monoxide, persulfate, copper chloride, or ferric chloride.

Furthermore, as a pre-process for forming a conductor circuit by etching the conductor layer described above, to make fine pattern formation easier, the thickness may be 1-10 µm, or more preferably about 2-8 µm by etching the entire surface of the conductor layer in advance.

With such a printed wiring board as a core substrate, a multi-layer printed wiring board may be formed by forming a build-up wiring layer by forming a conductor layer and a resin insulating layer alternatively according to a normal method on the core substrate.

In such a multi-layer printed wiring board, it is preferable to make part of the outermost conductor layer on the pad for connecting bumps with a predetermined pitch, and the pitch between adjacent through-holes filled with plating formed in the core substrate is formed similar to the pitch of said pad for connecting bumps. With this structure, the wiring resistance may be reduced via chips mounted on PKG so that it has the advantage of obtaining a power supply.

Below is a description specifically of an example of a method for producing a printed wiring board according to the present invention.
(1) To produce a printed wiring board according to the present invention, an insulating resin base material laminated with copper foils on both sides may be used as a raw material.
   For this insulating resin base material, a hard laminated base material is used selected from among glass fabric epoxy resin base material, glass fabric bismaleimide-triazine resin base material, glass fabric polyphenylenether resin base material, non-woven aramid-epoxy resin base material, non-woven aramid -polyimide resin material, and in particular, it is most preferable to use a glass fabric epoxy resin base material.
   The thickness of said insulating resin base material is preferably in the range of about 100-500 µm. This is because, if the thickness is less than 100 µm, rigidity is insufficient, but if the thickness is more than 500 µm, it is difficult to fill plating in penetrating holes, which may cause voids.
   To form penetrating holes for forming through-holes by using a laser in said insulating resin base material, there are two methods: the direct laser method for penetrating both the copper foil and the insulating resin base material at the same time as laser irradiation, and the conformal method for penetrating the insulating resin base material with laser irradiation after the metal foil part to be a penetrating hole in the copper foil is removed by etching. The present invention may use either one.
   The thickness of this copper sheet may be adjusted by half-etching.
   It is preferable to use a double-sided copper clad laminate obtained by laminating and heat-pressing prepreg as a B stage by impregnating epoxy resin in a glass cloth and a copper foil as said insulating resin base material and a copper foil.
   This is because the position accuracy is good, as there is no misalignment of the wiring pattern or via position during the process after the copper sheets are etched.
(2) Next, a penetrating hole for forming a through-hole is made in the insulating resin base material by laser processing.
   When using double-side copper clad laminate to form a circuit substrate, first, laser irradiation is performed from a predefined position toward the metal foil laminated on one side of surface of the insulating resin base material to pass through the metal foil and to form a first opening position in which the diameter decreases inward from one surface of the insulating resin base material and that extends from one surface to near the center part of the insulating resin base material; or after forming a hole in which the diameter is nearly the same as the diameter of the through-hole on the surface by etching in advance at a predefined position of one side of the copper foil surface laminated on the insulating resin base material (mask for laser), carbon dioxide gas laser irradiation is performed using the hole as an irradiation mark to form a first opening portion in which the diameter decreases inward the insulating resin base material and that extends from one surface of the insulating resin base material to near the center part.
   Next, laser irradiation is performed from a position misaligned by predetermined distance from other surface of the insulating resin base material facing said predetermined position toward the metal foil laminated on other side of surface of the insulating resin base material to form a second opening position in which the diameter decreases inward from the one surface of the insulating resin base material and that extends from the other surface to near the center part of the insulating resin base material; or after forming a hole whose diameter is almost same as the diameter of the through-hole on the surface by etching in advance at a predefined position of other side of the copper foil surface laminated on the insulating resin base material (a mask for laser), carbon dioxide gas laser irradiation is performed using the hole as an irradiation mark to form a second opening portion in which the diameter decreases inward the insulating resin base material and that extends from the other surface of the insulating resin base material to near the center part.
   When forming this second opening portion, the distance between the center of gravity of the first opening portion and the second opening portion (misalignment distance) is adjusted in accordance with the position of laser irradiation so that the first opening portion and the second opening portion is connected around the center part of the insulating resin base material to form a penetrating hole for forming a through-hole and the plane area enclosed by lines connecting the neck portions is not parallel to the base material plane (Refer to Fig. 2).
   The laser processing described above is performed with a pulse-oscillated type of carbonic acid gas laser device, and the processing conditions are determined by the shape of the penetrating hole for forming a through-hole in which the diameter decreases inward from the surface of the insulating resin base material and for example, the pulse duration is 10-20 µs while the number of shots is 1-5.
   With such laser processing conditions, the diameter of openings (the opening diameter of the first opening portion and the second opening portion) of a penetrating hole for forming a through-hole may be 75-300 µm and the shortest diameter of the neck portion may be 50-250 µm, and the misalignment distance of the position of the center of gravity of a penetrating hole for forming a through-hole may be in a range of 5-30 µm.
(3) The desmere process is performed to remove resin residual left in side wall of perforations formed in the step (2) described above.
   This desmear process is performed by wet processing such as chemical reaction of acids of or oxidants (e.g., chrome acid, permanganic acid) by dry processing such as oxygen plasma discharge treatment, corona discharge treatment, ultra violet laser processing or excimer laser processing.
(4) Then, nonelectrolytic plating process is performed to form an electroless plated film on inner wall of the penetrating hole for a through-hole and on the copper foil. In this case, the electroless plated coat may be made by using metals such as copper, nickel or silver.
(5) In addition, using the electroless plated film formed in the (4) above as a lead, electrolytic plating process is performed to form an electrolytic plated film on the electroless plated film covered with the copper foil of the base material as well as to make the plated layer attached and formed on inner wall of penetrating holes thicker gradually so that a drum shape of through-hole is formed by filing the electrolytic plated film inside the penetrating hole.
(6) Then, a etching resist layer is performed on the electrolytic copper plated film formed on the base material in the step (5) above. The etching resist layer may be created using a method of applying resist solution or a method of pasting one made to be film in advance. On this resist layer, a mask is positioned to which a circuit is drawn in advance, and exposed and developed to form an etching resist layer. A conductor circuit pattern containing through-hole land is formed by etching the metal layer in the parts where the etching resist is not formed.

As a etching solution, at least one kind of water solution is preferred which is selected from water solution of sulphate-hydrogen monoxide, persulfate, copper chloride, or ferric chloride.

As a pre-process to form a conductor circuit by the etching process described above, to make the formation of fine patterns easier, the thickness may be adjusted by etching the entire surface of the electrolytic copper plated film in advance.

Using the printed wiring board according to the present invention created by following the steps (1) to (6) described above as a core, a multi-layer printed wiring board may be formed by forming a build-up wiring layer made from layering the insulating resin layer and the conductor circuit layer alternatively on either side or both sides of the core substance.

In this multi-layer printed wiring board, a solder resist layer is each formed on the surface of the insulating resin layer on which the outermost layer of the build-up wiring layer, i.e., the outermost conductor circuit. In this case, a solder resist composition is applied on the entire surface of the outermost layer of the base material, and after the applied coat is dried, a photo mask film on which the opening portion of connection pad is drawn is placed on this applied coat and then exposed and developed to expose the connection pad part. In this case, one made from the solder resist layer to be dried film may be pasted and then exposed and developed or by using laser to form an opening.

On the connection pad exposed from the solder resist, a corrosion-resistant layer is formed such as nickel-gold. At this timing, the thickness of the nickel layer is preferably 1-7 µm and the thickness of the gold layer is preferably 0.01-0.1 µm. Other than those metals, nickel-paradium-gold, gold (single layer) or silver (single layer) as such may be formed.

Then, on the connection pad, a solder body is supplied and with melting or solidifying of this solder body, a solder bump is formed to form a multi-layer circuit base material.

In the multi-layer printed wiring board formed in the steps described above, the outermost conductor layer is formed as a connection pad in predetermined pitch, and by forming the pitch of this connection pitch similar to the pitch between adjacent through-holes filled with plating formed in the core substrate, the wiring resistant may be reduced via chips mounted on PKG so that it has advantage from a power supply point of view.

### Embodiments

### Embodiment 1-1

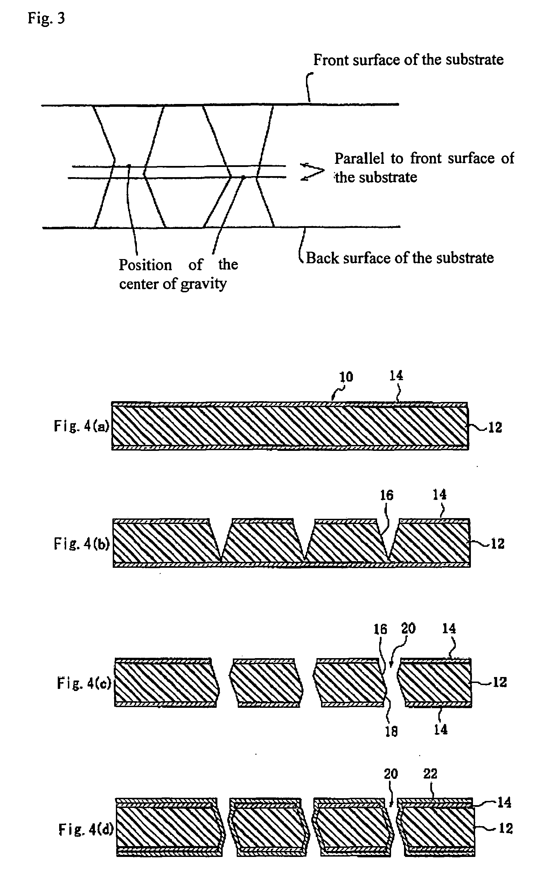

(1) First, a circuit board (core) is produced as a unit comprising a multi-layer printed wiring board. This circuit board is the substrate to be the center of laminate of multiple insulating layers to be laminated, and uses double-sided copper clad laminate 10, which is obtained by heat-pressing the prepreg made as B stage by impregnating epoxy resin in glass cloth and a copper sheet (Refer to Fig. 4(a)).
The thickness of said insulating resin base material 12 is 300 µm and the thickness of the copper foil 14 is 3 µm. By using a copper foil of this laminate which is thicker than 3, the thickness of the copper sheet may be adjusted to 3 µm by etching process.
(2) Carbon dioxide gas laser irradiation is performed on a predetermined position on the other surface of double-side circuit board 10 to form the first opening portion 16 which passes through the other copper sheet 14 and goes from the center depthwise of the insulating resin base material 12 to a portion close to another surface (Refer to Fig. 4 (b)), as well as carbon dioxide gas laser irradiation is performed on the position which is out of alignment by 15 µm from the position corresponding to said predetermined position of another surface of double-side circuit board 10 to form the second opening portion 18 which passes through the another copper sheet 14 and goes from the center depthwise of the insulating resin base material 12 to a portion close to the other surface so as to connect to said first opening portion 16. As a result, by connecting the first opening portion 16 and the second opening portion 18, the perforation 20 for forming a through-hole is formed.
As well, in this embodiment, to form the penetrating hole 20 for forming a through-hole, for example, a high peak short pulse oscillating type of carbon gas laser device made by Hitachi Via Co., Ltd is used under the laser processing conditions in which the pulse duration is 10-20 µs and the number of shots is 1-5. The penetrating hole 20 is formed with 150 µm pitch so as the opening diameter of the first opening portion 16 and the second opening portion 18 is almost 150 µm as well as the diameter of the neck portion around the center depthwise of the substrate, i.e., the minimum distance where the diameter is decreased at most (Indicated by X in Fig. 1) is almost 87 µm and the misalignment distance between the axis of the center of gravity of the first opening portion 16 and the axis of the center of gravity of the second opening portion 18 is 15 µm.
In the penetrating hole 20 formed under such condition, the first opening portion 16 and the second opening portion 18, whose center axes are out of alignment with each other are formed, are formed by a part of the base of a cone in which the inner wall is making a taper (inner angle) against the surface of the insulating resin base material 12, and connected by the common connecting cross-section around the center depthwise of the base material.
This connecting cross-section (Refer to Fig. 2) is not parallel to the surface of the insulating resin base material. In addition, the position of the center of gravity of adjacent connection cross-sections is preferably out of alignment in the cross-section direction of the insulating resin base material (Refer to Fig. 3).
(3) Then, the desmere process is performed inside the penetrating hole 20 formed by laser processing to remove resin or particle residue left on the inner wall with a physical method such as 02 plasma or CF4 plasma. In addition, soft etching process may be performed on the desmere processed base material after washing with water and acidity delipidation.
(4) Next, the desmere processed substrate is dipped in the electroless copper plating water solution made up as described below to form the electroless copper plated film 22 0.6 µm thick on the entire surface of the copper foil 14 laminated on both sides of the substrate and the inner wall of the penetrating hole 20 (Refer to Fig. 4 (d)).

| *Electroless copper plating solution* | |
|---|---|
| Copper sulphate: | 0.03 mol/l |
| EDTA: | 0.200 mol/l |
| HCHO: | 0.18 g/l |
| NaOH: | 0.100 mol/l |
| α,α'-bipiridyl: | 100 mg/l |
| Polyethleneglycol: | 0.10 g/l |
| (Plating condition) | |
| Solution temperature: | 30-50°C |
| Duration: | 40-60 minutes |

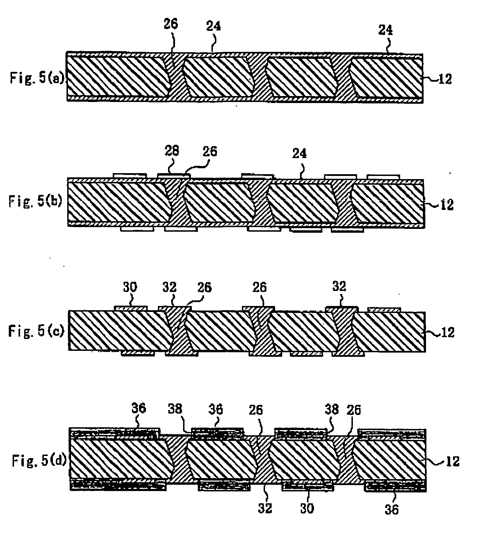

(5) Next, after the substrate is washed in 50°C water for delipidation and washed in 25°C water, and then washed again with sulphate and electrolysis plating is performed under the condition below to form the electrolysis plated film 24 (Refer to Fig. 5 (a)).

| *Electrolysis copper plating solution* | |
|---|---|
| Sulphate: | 2.24 mol/l |
| Copper sulphate: | 0.26 mol/l |
| Additive agent: | 19.5 ml/l |
| Leveling agent: | 50 mg/l |
| Gloss agent: | 50 mg/l |

| *Electrolysis plating condition* | |
|---|---|
| Current density: | 1.0 A/dm² |
| Duration: | 30-90 minutes |
| Temperature: | 22±2°C |

(6) Noted that, in Fig. 5, the electroless plated film 22 is not shown for simplification. On the substrate on which said electrolytic copper plated film is formed, the film resist layer is attached. And on this resist layer, a mask on which a circuit is drawn in advance is positioned, and exposed and developed to form the etching resist layer 28 (Refer to Fig. 5 (b)). Then by etching the metal layer in the part where the etching resists is not formed, the conductor circuit 30 having 20-30 µm thick inner layer is formed on the front and back surface of the insulating resin base material as well as the core substrate is produced by forming the through-hole land 32 positioning on top of the through-hole 26 (Refer to Fig. 5 (c)).
As well, the wiring is formed which connects 100 through-holes via the conductor circuit 30 and through-hole land 32.
Then, the inter layer resin insulating layer and the conductor layer are stacked alternatively on the core substrate to form the build-up wiring layer to form a multi-layered printed wiring board.
(7) After washing with water and acid degreasing, and then soft-etching the substrate above, the etching solution is applied on both sides of the substrate with a spray and the surface of the inner layer conductor circuit 30 (including the through-hole land 32) is etched to form the rough surface (Not shown) on the entire surface of the inner layer conductor circuit 30 (including the through-hole land 32).
The etching solution (MEC, MEC Etch Bond) consisted of 10 parts by weight of imidazole copper (II) complex, 7 parts by weight of glycol acid and 5 parts by weight of porassium chloride is used as the etching solution.
(8) On both sides of the base material, a resin film for inter layer resin insulating (e.g., ABF made by Ajinomoto) which is slightly bigger than the base material is positioned on the base material and temporarily pressure-bonded under the condition which is 0.4 MPa pressure, 80°C temperature and 10 seconds of pressure bonding time, and cut, and then, applied with the following method by using the vacuum laminating device to form the inter layer resin insulating layer 36. i.e., the resin film for inter layer resin insulating layer is permanently press-bonded on the base material under the condition of 67 Pa vacuum, 0.4 MPa pressure, 80°C temperature, and 60 seconds pressure bonding time and then hardened for 30 minutes at 170°C.
(9) Next, on the inner layer resin insulating layer 36, via the mask in which 1.2 mm thick of perforations are formed, with 10.4 µm pulse length of CO2 gas laser, under the condition of 4.0 mm beam diameter, top hat mode, 8.0 µseconds pulse duration, 1.0 mm diameter of mask perforation hole, and 1-3 shots, the opening 38 for via hole with 60 µm diameter is formed on the inner layer resin insulating layer (Refer to Fig. 5 (d)).
(10) The substrate on which the opening 38 for via hole is performed is dipped in the 80°C solution containing 60 g/l of permanganic acid for 10 minutes to remove particles existing on the surface of the inner layer resin insulating layer 36 so that the surface of the inner layer resin insulating layer 36 containing the inner wall of the opening 38 for via hole becomes rough surface (not shown).
(11) Then the substrate from the step above is dipped in the neutralization solution (made by Shipley) and washed in water.
In addition, on the surface of said substrate processed with rough surface (rough depth 3 µm), by applying palladium catalyst, catalyst core is attached on the surface of the inner layer resin insulating layer 36 and the inner wall of the opening 38 for via hole (Not shown). i.e., the substrate above is dipped in the catalyst solution containing palladium chloride (PdCl2) and stannous chloride (SnCl2) to apply the catalyst by separating out palladium metal.
(12) Next, the catalyst applied substrate is dipped in the electroless copper plating solution that made up as follows to form the 0.6-3.0 µm thick of electroless copper plated film on the entire rough surface to obtain the base material in which the electroless copper plated film (not shown) is formed on the surface of the inner layer resin insulating layer 36 including the inner wall of the opening 38 for via hole.

| *Electrolysis copper plating water solution* | |
|---|---|
| Copper sulphate: | 0.03 mol/l |
| EDTA: | 0.200 mol/l |
| HCHO: | 0.18 g/l |
| NaOH: | 0.100 mol/l |
| α,α'-bipiridyl: | 100 mg/l |
| Polyethleneglycol: | 0.10 g/l |

*Plating condition*
Solution temperature: 30-50°C
Duration: 40-60 minutes
(13) A commercially available photosensitive dry film is pasted on the electroless copper plated film formed substrate and a mask is placed and exposed at 100 mJ/cm2 and developed with 0.8% sodium carbonate aqueous solution to form the 20 µm thick plated resists (not shown).
(14) Next, after the substrate is washed in 50°C water for delipidation and washed in 25°C water, and then washed again with sulphate, electrolysis plating is performed under the condition below to form the electrolysis plated film.

| *Electrolysis plating solution* | |
|---|---|
| Sulphate: | 2.24 mol/l |
| Copper sulphate: | 0.26 mo/l |
| Additive agent: | 19.5 ml/l |
| Leveling agent: | 50 mg/l |
| Gloss agent: | 50 mg/l |

| *Electrolysis plating condition* | |
|---|---|
| Current density: | 1 A/dm² |
| Duration: | 65 minutes |
| Temperature: | 22±2°C |

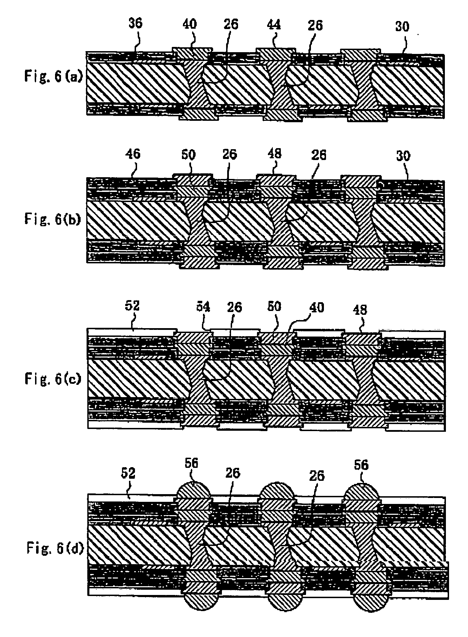

In this plating process, a 20 µm thick electrolytic copper plating film is formed in the parts where plated resist is not formed as well as an electrolytic plated layer is filled in the opening 38 for a via hole.
(15) In addition, after the plated resist is detached and removed with 5% KOH, the electroless plated film under the resist is dissolved and removed by the etching process with mixed solution with sulphuric acid and hydrogen peroxide to form the filled via 40 containing via land and an independent external layer conductor circuit 44 (Refer to Fig. 6 (a)).
(16) Then, a process same as (8) described above is performed to form rough surface (not shown) on the surface of the filled via 40 on the surface of the external layer conductor circuit 44.
(17) By repeating the steps from (8) to (15) described above, the external layer between-layer insulating layer 46, the external layer conductor circuit 48 and the filled via 50 are further formed to obtain a multi-layer wiring board (Refer to Fig. 6 (b)).
(18) Next, on both sides of the multi-layer wiring board, commercially available solder resist composition is applied for 20 µm thickness, and dried under the condition which is for 20 minutes at 70°C and for 30 minutes at 70°C, a photo mask 5 mm thick on which the solder resist opening portion patter is drawn is contacted on the solder resist layer, and exposed to 1000 mJ/cm² ultra violet, and then developed to form the opening 54 whose diameter is 60 µm (Refer to Fig. 6 (c)).
Then, in addition, heating process is performed for each under the condition which is for one hour at 80°C, one hour for 100°C, one hour for 120°C, and three hours for 150°C to harden the solder resist layer to form the solder resist pattern layer 52 20 µm thick having openings.
(19) Then, the base material on which the solder resist layer 52 is formed is dipped in nonelectrolytic nickel plating solution containing nickel chloride (2.3 × 10⁻¹ mol/l), sodium hypophosphite (2.8 × 10⁻¹ mol/l), citric sodium (1.6 × 10⁻¹ mol/l) of pH = 4.5 for 20 minutes to form the nickel plated layer 5 µm thick (not shown) at the opening portion 54. In addition, the base material is dipped in nonelectrolytic plating solution containing potassium gold cynanide (7.6 × 10⁻³ mol/l), ammonium chloride (1.9 × 10⁻¹ mol/l), citric sodium (1.2 × 10⁻¹ mol/l), and sodium hypophosphite (1.7 × 10⁻¹ mol/l) for 7.5 minutes at 80°C to form a gold plated layer (not shown) 0.03 µm thick on the nickel plated layer.
(20) In addition, on the opening 54 of the solder resist layer 52 on the side where the board IC chip is positioned, solder paste containing tin-lead is printed and on the opening 54 on the solder resist layer 52 on other side, solder paste containing tin-antimony is printed, then, by reflow at 230°C, the solder bump 56 is formed to produce the multi-layer printed wiring board (Refer to Fig. 6 (d)).

### Embodiment 1-2

Other than forming a penetrating hole 20 by irradiating laser beam, with the misalignment distance of the axes of the center of gravity between the first opening portion 16 and the second opening portion 18 is 5 µm, and the diameter of neck portion is 76 µm, a multiple layer printed wiring board is created in same manner as Embodiment 1-1.

### Embodiment 1-3

Other than forming a penetrating hole 20 by irradiating laser beam, with the misalignment distance of the axes of the center of gravity between the first opening portion 16 and the second opening portion 18 is 10 µm, and the diameter of neck portion is 80 µm, a multiple layer printed wiring board is created in same manner as Embodiment 1-1.

### Embodiment 1-4

Other than forming a penetrating hole 20 by irradiating laser beam, with the misalignment distance of the axes of the center of gravity between the first opening portion 16 and the second opening portion 18 is 20 µm, and the diameter of neck portion is 91 µm, a multiple layer printed wiring board is created in same manner as Embodiment 1-1.

### Embodiment 1-5

Other than forming a penetrating hole 20 by irradiating laser beam, with the misalignment distance of the axes of the center of gravity between the first opening portion 16 and the second opening portion 18 is 25 µm, and the diameter of neck portion is 97 µm, a multiple layer printed wiring board is created in same manner as Embodiment 1-1.

### Embodiment 1-6

Other than forming a penetrating hole 20 by irradiating laser beam, with the misalignment distance of the axes of the center of gravity between the first opening portion 16 and the second opening portion 18 is 30 µm, and the diameter of neck portion is 110 µm, a multiple layer printed wiring board is created in same manner as Embodiment 1-1.

### Reference 1-1

Other than forming a penetrating hole 20 by irradiating laser beam, with the misalignment distance of the axes of the center of gravity between the first opening portion 16 and the second opening portion 18 is 3 µm, and the diameter of neck portion is 74 µm, a multiple layer printed wiring board is created in same manner as Embodiment 1-1.

### Reference 1-2

Other than forming a penetrating hole 20 by irradiating laser beam, with the misalignment distance of the axes of the center of gravity between the first opening portion 16 and the second opening portion 18 is 35 µm, and the diameter of neck portion is 95 µm, a multiple layer printed wiring board is created in same manner as Embodiment 1-1.

In Embodiments 1-1 to 1-6 and References 1-1 to 1-2, using a double-sided copper clad laminate in which the insulating resin base material is 100 µm, and other than setting the diameter of the first opening portion 16 and the second opening portion 18 as 75 µm by changing the opening diameter of the mask for laser and the carbonic acid gas laser irradiation condition, with same manner, a multi-layer printed wiring board is produced which are called Embodiments 2-1 to 2-6 and References 2-1 to 2-2.
The misalignment distance of axes of the center of gravity and the diameter of the neck portion in those cases are listed in Table 1 and Table 2.

Also, in Embodiments 1-1 to 1-6 and References 1-1 to 1-2, using a double-sided copper clad laminate in which the insulating resin base material is 500 µm, and other than setting the diameter of the first opening portion 16 and the second opening portion 18 as 300 µm by changing the opening diameter of the mask for laser and the carbonic acid gas laser irradiation condition, with same manner, a multi-layer printed wiring board is produced which are called Embodiments 3-1 to 3-6 and References 3-1 to 3-2.
The misalignment distance of axes of the center of gravity and the diameter of the neck portion in those cases are listed in Table 2.
The evaluation test such as A described below is performed on the multi-layer printed wiring boards produced according to Embodiments 1-1 to 3-6 and References 1-1 to 3-2 described above. The result of those evaluation tests are shown in Table 1 and Table 2.

### A. Heat cycle test

The connection resistance of wiring that connects the conductor circuits on the front and back of the core substrate of the multi-layer printed wiring board via 100 through-holes_is measured (initial value), and then, under the heat cycle condition where -55°C for 5 minutes and 125°C for 5 minutes is as one cycle, 1,000 times of cycle test is repeated, and again the connection resistance is measured.
At this timing, if the connection resistance variation (100 × (the connection resistance value after the heat cycle - the initial value of connection resistance) / the initial value of connection resistance) is within 10%, it is passed (indicated by O) while if beyond 10%, it is failed (indicated by X).
As a result of the measurement, all the embodiments passed while all the reference examples failed.

For the core substance of the multi-layer printed wiring board in each reference example, whether any voids exist in plating filled in perforation (through-holes) is observed using X-ray TV system (Shimadzu, product name "SMX-100"). 100 through-holes are selected randomly to be observed.

Many voids are confirmed in the core substances in each reference example. It is assumed that voids are occurred when misalignment distance is small because plating solution entering into the through-holes from the front and back of the core substance is collided head-on. On the other hand, when the misalignment distance is beyond 30 µm, the penetrating holes are prone to deform as shown in Fig. 7 (a) - (b) because the misalignment distance is too big.

**Table 1**

| | Board Thickness (µm) | First and second opening diameter (µm) | Misalignment of axis of the center of alignment (µm) | Neck portion diameter (µm) | Heat cycle test result |
|---|---|---|---|---|---|
| Embodiment 1-1 | 300 | 150 | 15 | 87 | ○ |
| Embodiment 1-2 | 300 | 150 | 5 | 76 | ○ |
| Embodiment 1-3 | 300 | 150 | 10 | 80 | ○ |
| Embodiment 1-4 | 300 | 150 | 20 | 91 | ○ |
| Embodiment 1-5 | 300 | 150 | 25 | 97 | ○ |
| Embodiment 1-6 | 300 | 150 | 30 | 110 | ○ |
| Reference 1-1 | 300 | 150 | 3 | 74 | X |
| Reference 1-2 | 300 | 150 | 35 | 95 | X |
| Embodiment 2-1 | 100 | 75 | 15 | 37 | ○ |
| Embodiment 2-2 | 100 | 75 | 5 | 24 | ○ |
| Embodiment 2-3 | 100 | 75 | 10 | 30 | ○ |
| Embodiment 2-4 | 100 | 75 | 20 | 40 | ○ |
| Embodiment 2-5 | 100 | 75 | 25 | 45 | ○ |
| Embodiment 2-6 | 100 | 75 | 30 | 49 | ○ |

**Table 2**

| | Board Thickness (µm) | First and second opening diameter (µm) | Misalignment of axis of the center of alignment (µm) | Neck portion diameter (µm) | Heat cycle test result |
|---|---|---|---|---|---|
| Reference 2-1 | 100 | 75 | 3 | 24 | X |
| Reference 2-2 | 100 | 75 | 35 | 40 | X |
| Embodiment 3-1 | 500 | 300 | 15 | 162 | ○ |
| Embodiment 3-2 | 500 | 300 | 5 | 156 | ○ |
| Embodiment 3-3 | 500 | 300 | 10 | 160 | ○ |
| Embodiment 3-4 | 500 | 300 | 20 | 161 | ○ |
| Embodiment 3-5 | 500 | 300 | 25 | 168 | ○ |
| Embodiment 3-6 | 500 | 300 | 30 | 170 | ○ |
| Reference 3-1 | 500 | 300 | 3 | 150 | X |
| Reference 3-2 | 500 | 300 | 35 | 160 | X |

From the result of the evaluation test A above, in a printed wiring board produced according to each embodiment, it is confirmed that cracking is prevented around the center part in which the diameter plated through-hole decreases and good electric connectivity and mechanical strength are obtained.

In each embodiment described above, penetrating holes formed in the insulating resin base material (core substrate) are filled with plating, however, the heat cycle test result is same for the amount of misalignment even for a through-hole (Refer to Fig. 8) by forming through-hole conductors on inside wall of the penetrating hole and then filling a filler in a gap enclosed by the through-hole conductors.

### Possibilities for industrial use

As described above, the present invention provides a printed wiring board that has advantages to reduce occurrence of defects such as voids or cracking, to reduce poor connection on the base material, and to improve the mechanical strength of the board.

## Claims

1. A printed wiring board having a through-hole filling a penetrating hole provided in an insulating resin base material with a plating,
wherein the position of axis of the center of gravity of each through-hole exposed from the front surface and back surface of said insulating resin base material is out of alignment with each other.

2. A printed wiring board having a through-hole filling a penetrating hole provided in an insulating resin base material with a plating, wherein a resin insulating layer and an external layer of a conductor circuit are alternately formed on a core substrate having an inner layer of a conductor circuit electrically connected by said through-hole both on the front surface and back surface of said insulting resin base material; and
the position of axis of the center of gravity of each through-hole exposed from the front surface and back surface of said insulating resin base material is out of alignment with each other.

3. A printed wiring board according to Claim 1 or Claim 2 wherein said displaced amount is 5-30 µm.

4. A printed wiring board according to Claim 1 or Claim 2 wherein the thickness of said insulating resin base material is 100-500 µm.

5. A printed wiring board according to Claim 1 or Claim 2 wherein said through-holes are in a shape having a neck portion in which the diameter decreases inward from the front surface and back surface of said insulating resin base material; the diameter of the opening exposed on each front surface and back surface of said insulating resin base material is 75-300 µm and the diameter of the neck portion inside said insulating resin base material is 50-250 µm.

6. A printed wiring board according to Claim 1 or Claim 2 wherein the pitch between adjacent through-holes is 100-400 µm.

7. A manufacturing method for producing a printed wiring board, to produce a printed wiring board having a through-hole filling a penetrating hole passing through an insulating resin base material with a plating, and having conductor circuits electrically connected via said through-holes on the front surface and back surface of said insulating resin base material, which includes at least steps (1) to (4) below, as follows;
(1) A step of forming a first opening portion having a shape in which the diameter decreases depthwise of the insulating resin base material by irradiating, with a laser, a predetermined position on one surface of a copper clad laminate on which copper foil is laminated on both sides of the insulating resin base material;
(2) A step of forming a second opening portion for connection with said first opening portion around the center of the depth of the insulating resin base material, and for forming a shape in which the diameter decreased inward of said insulating resin base material by irradiating, with a laser, a position that does not overlap the position of the center of gravity of said first opening portion from a location on another surface of said copper clad laminate facing to said predetermined position across said insulating resin base material;
(3) A step of forming an electroless plated film on the inner wall of said first and a second opening portion by performing nonelectrolytic plating on said base material;
(4) A step of forming an electrolytically plated layer on said electroless plated film and forming through-holes filled with plating inside said first and second opening portions by performing electrolytic plating on said base material.
